(19) Europäisches Patentamt
European Patent Office
Office européen des brevets

(11) EP 3 640 736 A1

(12) EUROPEAN PATENT APPLICATION

(43) Date of publication:
22.04.2020 Bulletin 2020/17

(51) Int Cl.:
G03F 7/20 (2006.01)

(21) Application number: 19201008.0

(22) Date of filing: 02.10.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 02.10.2018 KR 20180117729

(71) Applicant: Samsung Display Co., Ltd.
Gyeonggi-Do (KR)

(72) Inventors:
• YOON, Seok Kyu
  Chungcheongnam-do (KR)
• NAGAI, Shinichiro
  Chungcheongnam-do (KR)

(74) Representative: Shearman, James Ward
Marks & Clerk LLP
15 Fetter Lane
London EC4A 1BW (GB)

(54) **EXPOSURE METHOD AND METHOD OF MANUFACTURING DISPLAY APPARATUS USING THE SAME**

(57) An exposure method for stepwise moving a rectangular mask and a relative position of a substrate includes first shot exposure in which the mask is located on a first region of the substrate, coordinates of two points on one side of the mask are detected, the mask is aligned using the coordinates, and then a first shot is exposed, second shot exposure in which the mask is located on a second region of the substrate, coordinates of two points on one side of the mask are detected, the mask is aligned using the coordinates, and then a second shot is exposed, and third shot exposure in which the mask is located on a third region of the substrate, coordinates of two points on one side of the mask are detected, the mask is aligned using the coordinates, and then a third shot is exposed.

FIG. 1

**Description**

**BACKGROUND**

**1. Field**

Embodiments of the inventive concept relate to an exposure method and a method of manufacturing a display apparatus using the exposure method.

**2. Description of the Related Art**

Recently, a display apparatus having light weight and small size has been manufactured. A cathode ray tube (CRT) display apparatus has been used due to performance and a competitive price. However the CRT display apparatus has a weakness with a size or portability. Therefore, a display apparatus, such as a plasma display apparatus, a liquid crystal display apparatus, and an organic light emitting display apparatus, has been highly regarded due to small size, light weight, and low power consumption.

The display apparatus may include a pattern such as a color filter and the like formed on a substrate. The patterns can be formed by exposing and developing a photoresist layer with a patterned mask. At this time, as the display apparatus may be made larger, when a size of the display apparatus is larger than a size of the mask, a method of performing exposure and development through a plurality of shots using a stepwise exposure device may be used. However, there is a problem that display quality may be degraded by stitch stains formed at the boundaries of a plurality of exposure regions.

**SUMMARY**

According to an aspect of one or more embodiment of the inventive concept, a stepwise exposure method is provided in which stitch stains are reduced.

According to another aspect of one or more embodiments of the inventive concept, a method of manufacturing a display apparatus using such an exposure method is provided.

According to one or more embodiments of the inventive concept, an exposure method for stepwise moving a rectangular mask and a relative position of a substrate, which is divided into a plurality of regions, and exposing each of the regions to a shot, includes first shot exposure in which the mask is located on a first region of the plurality of regions of the substrate, coordinates of two points on one side of the mask are detected, the mask is aligned using the coordinates, and then a first shot is exposed, second shot exposure in which the mask is located on a second region of the plurality of regions of the substrate, coordinates of two points on one side of the mask adjacent to the first shot region are detected, the mask is aligned using the coordinates, and then a second shot is exposed, and third shot exposure in which the mask is located on a third region of the plurality of regions of the substrate, coordinates of two points on one side of the mask adjacent to an already exposed adjacent shot region are detected, the mask is aligned using the coordinates, and then a third shot is exposed.

In an embodiment, the first region, the second region, and the third region may be sequentially continuously arranged. Alignment in the first shot exposure may be performed by aligning one side of the mask on one side of the first region. Alignment in the second shot exposure may be performed by aligning one side of the mask on one side of the first shot. Alignment in the third shot exposure may be performed by aligning one side of the mask on one side of the second shot.

In an embodiment, in the first shot exposure, when the mask is located within an alignment offset range, it is considered that alignment is completed, and then the first shot may be exposed. In the second shot exposure, the mask may be aligned using a difference amount that is offset from an alignment target coordinate.

In an embodiment, in the second shot exposure, coordinates of two other points opposite to the two points at which the alignment is performed when the second shot is exposed are detected and stored. The mask may be aligned using the coordinates of the two other points in the third shot exposure.

In an embodiment, detected coordinates and aligned coordinates have values of $(X, Y, \theta)$, respectively, where X is an X coordinate, Y is a Y coordinate, and $\theta$ is calculated by the following equation)

$$\Theta_1 k = \tan^{-1} \frac{(Y_1 k - Y_1 kc)}{(X_1 k - X_1 kc)}$$

$$\theta_①c = \sum_{k=1}^{4}(\theta_①k - \theta_①k0)/4$$

where k is a corner number, and c is average of four corners of each shot, in the first shot exposure, the coordinates of the two points detected are $(X_①1, Y_①1, \theta_①1)$ and $(X_①2, Y_①2, \theta_①2)$, in the first shot exposure, the alignment target coordinate $(X_①, Y_①, \theta_①)$ of the mask is calculated by the following equations:

$$X_① = -(X_①1 + X_①2)/2$$

$$Y_① = -(Y_①1 + Y_①2)/2$$

$$\theta_① = -(\theta_①1 + \theta_①2)/2$$

and a difference amount $(\Delta X_①, \Delta Y_①, \Delta\theta_①)$ between actual position of the mask and the alignment target coordinate $(X_①, Y_①, \theta_①)$ within an alignment offset range when the first shot is exposed is stored.

In an embodiment, in the second shot exposure, the coordinates of the two points detected may be $(X_②3, Y_②3, \theta_②3)$ and $(X_②4, Y_②4, \theta_②4)$. In the second shot exposure, the alignment target coordinate $(X_②, Y_②, \theta_②)$ of the mask may be calculated by the following equations:

$$X_② = \Delta X_① - (X_②3 + X_②4)/2$$

$$Y_② = \Delta Y_① - (Y_②3 + Y_②4)/2$$

$$\theta_② = \Delta\theta_① - (\theta_②3 + \theta_②4)/2$$

and coordinates of two other points opposite to the two points at which the alignment is performed when the second shot is exposed may be detected, a difference amount $(\Delta X_②', \Delta Y_②', \Delta\theta_②')$ between the coordinates of the two other points which are detected and coordinates of corresponding two points in the second region may be stored.

In an embodiment, in the third shot exposure, the coordinates of the two points detected may be $(X_③3, Y_③3, \theta_③3)$ and $(X_③4, Y_③4, \theta_③4)$. In the third shot exposure, the alignment target coordinate $(X_③, Y_③, \theta_③)$ of the mask may be calculated by the following equations:

$$X_③ = \Delta X_②' - (X_③3 + X_③4)/2$$

$$Y_③ = \Delta Y_②' - (Y_③3 + Y_③4)/2$$

$$\theta_③ = \Delta\theta_②' - (\theta_③3 + \theta_③4)/2.$$

In an embodiment, in the third shot exposure, coordinates of two other points opposite to the two points at which the alignment is performed when the third shot is exposed may be detected, a difference amount $(\Delta X_③', \Delta Y_③', \Delta\theta_③')$ between the coordinates of the two other points which are detected and coordinates of corresponding two points in the third region may be stored. In the fourth shot exposure, the coordinates of the two points detected may be $(X_④3, Y_④3, \theta_④3)$ and $(X_④4, Y_④4, \theta_④4)$. In the fourth shot exposure, the alignment target coordinate $(X_④, Y_④, \theta_④)$ of the mask may be calculated by the following equations:

$$X_④ = \Delta X_③' - (X_④3 + X_④4)/2$$

$$Y④ = \Delta Y③'-(Y④3+Y④4)/2$$

$$\theta④ = \Delta\theta③'-(\Theta④3+\theta④4)/2.$$

In an embodiment, the first region may be between the second region and the third region.

In an embodiment, in the second shot exposure, the mask may slide along a stitch line formed by contacting the first shot and the second shot by a certain amount (e.g., a predetermined amount) to be aligned.

In an embodiment, in the second shot exposure, an amount of sliding of the mask may be determined by using the coordinates of four points of the mask.

In an embodiment, in the second shot exposure, the alignment target coordinate (X②, Y②, θ②) of the mask may be calculated by the following equations:

$$X② = \Delta X①-(X②3+X②4)/2+\Delta X②s$$

$$Y② = \Delta Y①-(Y②3+Y②4)/2+\Delta Y②s$$

$$\theta② = \Delta\theta①-(\theta②3+\theta②4)/2$$

wherein slip amounts ΔX②s, ΔY②s may be calculated by the following equations:

$$\Delta Y②a=\{[(Y②3+Y②4)/2]\cdot(a/0.5)+[\sum_{k=1}^{4}(Y②k)/4\cdot(1-a)/0.5]]/2$$

$$\Delta Y②s=\Delta Y②a-(Y②3+Y②4)/2$$

$$\Delta X②s=\Delta Y②s\cdot[(X①1-X①2)/(Y①1-Y①2)]$$

wherein "a" is a weight value and may be set to a value between 0 and 1. Coordinates of the two other points opposite to the two points at which the alignment is performed when the second shot is exposed may be detected, a difference amount (ΔX②', ΔY②', Δθ②') between the coordinates of the two other points which are detected and coordinates of corresponding two points in the second region may be stored.

In an embodiment, in the third shot exposure, the alignment target coordinate (X③, Y③, θ③) of the mask may be calculated by the following equations:

$$X③ = \Delta X②-(X③3+X③4)/2+\Delta X③s$$

$$Y③ = \Delta Y②-(Y③3+Y③4)/2+\Delta Y③s$$

$$\theta③ = \Delta\theta②-(\theta③3+\theta③4)/2$$

wherein slip amounts ΔX②s, ΔY②s may be calculated by the following equations:

$$\Delta Y③a=\{[(Y③3+Y③4)/2]\cdot(a/0.5)+[\sum_{k=1}^{4}(Y③k)/4\cdot(1-a)/0.5]]/2$$

$$\Delta Y③s = \Delta Y③a - (Y③3 + Y③4)/2$$

$$\Delta X③s = \Delta Y③s \cdot [(X②1 - X②2)/(Y②1 - Y②2)]$$

wherein "a" is a weight value and may be set to a value between 0 and 1. Coordinates of two other points opposite to the two points at which the alignment is performed when the third shot is exposed may be detected, a difference amount $(\Delta X③', \Delta Y③', \Delta\theta③')$ between the coordinates of the two other points which are detected and coordinates of corresponding two points in the third region may be stored.

In an embodiment, the weight value "a" in the second shot exposure, and the weight value "a" in the third shot exposure may be different from each other.

In an embodiment, in the second shot exposure, an amount by which an additional offset value may be further added to the slide amounts $\Delta X②s$, $\Delta Y②s$ is slid.

According to one or more embodiments of the inventive concept, an exposure method for exposing a substrate comprising m regions with m shots includes first shot exposure aligned with respect to one side of a first region, N-th shot exposure aligned with respect to one side of an already exposed shot adjacent to the N-th region, where N is a natural number greater than 2 and less than m, and m-th shot exposure aligned with respect to one side of already exposed shot adjacent to the m-th region.

In an embodiment, in the N-th shot exposure, one side of the N-th shot may be slid along the one side of the already exposed shot to be aligned, and then the N-th shot may be exposed.

In an embodiment, a position which is slid may be calculated using at least two points corresponding to corners of the N-th shot.

According to one or more embodiments of the inventive concept, a method of manufacturing a display apparatus includes forming a photoresist layer on a substrate divided into a plurality of regions, exposing the photoresist layer using an exposure device for stepwise moving relative positions of the substrate and a mask and exposing the respective regions to respective shots, and developing the exposed photoresist layer to form a pattern. The developing includes first shot exposure in which the mask is located on a first region of the plurality of regions of the substrate, coordinates of two points on one side of the mask are detected, the mask is aligned using the coordinates, and then a first shot is exposed, second shot exposure in which the mask is located on a second region of the plurality of regions of the substrate, coordinates of two points on one side of the mask adjacent to the first shot region are detected, the mask is aligned using the coordinates, and then a second shot is exposed, and third shot exposure in which the mask is located on a third region of the plurality of regions of the substrate, coordinates of two points on one side of the mask adjacent to an already exposed adjacent shot region are detected, the mask is aligned using the coordinates, and then a third shot is exposed.

In an embodiment, in the second shot exposure, the mask may slide along a stitch line formed by contacting the first shot and the second shot by a certain amount (e.g., a predetermined amount) to be aligned.

According to an aspect of embodiments of the present inventive concept, in an exposure method, a rectangular mask and a relative position of a substrate, which is divided into a plurality of regions, are stepwise moved and each of the regions is exposed to each shot. According to the exposure method, the mask is located on the first region of the substrate, coordinates of two points on one side of the mask are detected, the mask is aligned using the coordinates, and then the first shot is exposed. The mask is located on the second region of the substrate, coordinates of two points on one side of the mask adjacent to the first shot region are detected, the mask is aligned using the coordinates, and then the second shot is exposed. The mask is located on the third region of the substrate, coordinates of two points on one side of the mask adjacent to an already exposed adjacent shot region are detected, the mask is aligned using the coordinates, and then the third shot is exposed. At this time, since each shot is two-point aligned with respect to the stitch line, unevenness of exposure around the stitch line of a plurality of shots can be minimized or reduced.

In addition, stitch stains can be reduced in a pattern formed using the above exposure method.

It is to be understood that both the foregoing general description and the following detailed description of some embodiments are explanatory and are intended to provide further explanation of the present disclosure as claimed.

At least some of the above and other features of the invention are set out in the claims.

## BRIEF DESCRIPTION OF THE DRAWINGS

The above and other features of the inventive concept will become more apparent by describing in further detail some embodiments thereof with reference to the accompanying drawings, in which:

FIG. 1 is a conceptual diagram of an exposure device used in an exposure method according to an embodiment of the inventive concept;

FIG. 2 is a flowchart showing an exposure method according to an embodiment of the inventive concept;

FIG. 3 is a plan view showing a plurality of shot areas formed according to the exposure method of FIG. 2;

FIG. 4 is an enlarged plan view showing an alignment mark of a substrate and an alignment mark of a mask at a corner portion of a first shot region in FIG. 3;

FIG. 5 is a plan view showing a plurality of shot regions formed according to an exposure method according to an embodiment of the inventive concept;

FIG. 6 is a plan view showing a plurality of shot regions formed according to an exposure method according to an embodiment of the inventive concept;

FIG. 7 is a flowchart illustrating an exposure method according to an embodiment of the inventive concept;

FIG. 8 is a flowchart illustrating an exposure method according to an embodiment of the inventive concept;

FIG. 9 is a cross-sectional view illustrating a display apparatus manufactured using an exposure method according to an embodiment of the inventive concept; and

FIG. 10 is a flowchart showing a method of manufacturing a display apparatus using an exposure method according to an embodiment of the inventive concept.

## DETAILED DESCRIPTION

Herein, the inventive concept will be explained in further detail with reference to the accompanying drawings.

In the figures, the thickness, ratio, and dimensions of components may be exaggerated for clarity of illustration. As used herein, the term "and/or" includes any and all combinations of one or more of the associated listed items.

As used herein, "include" or "comprise" specifies a property, a fixed number, a step, an operation, an element, a component, or a combination thereof, but does not exclude other properties, fixed numbers, steps, operations, elements, components, or combinations thereof.

Where an element is described as being related to another element, such as being "on" another element or "located on" a different element or a layer, this includes both a case in which an element is located directly on another element or a layer and a case in which an element is located on another element via another layer or still another element. In contrast, where an element is described as being related to another element, such as being "directly on" another element or "located directly on" a different element or a layer, this indicates a case in which an element is located on another element or a layer with no intervening element or layer therebetween.

Throughout the specification, the same reference numerals are used for the same or similar parts.

It is to be understood that, although the terms "first," "second," etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments and is not intended to be limiting of example embodiments. As used herein, the singular forms "a," "an," and "the" are intended to include the plural forms as well, unless the context clearly indicates otherwise.

Unless otherwise defined, all terms (including technical and scientific terms) used herein have the same meaning as commonly understood by one of ordinary skill in the art to which example embodiments of the inventive concept belong. It is to be further understood that terms, such as those defined in commonly-used dictionaries, should be interpreted as having a meaning that is consistent with their meaning in the context of the relevant art and will not be interpreted in an idealized or overly formal sense unless expressly so defined herein.

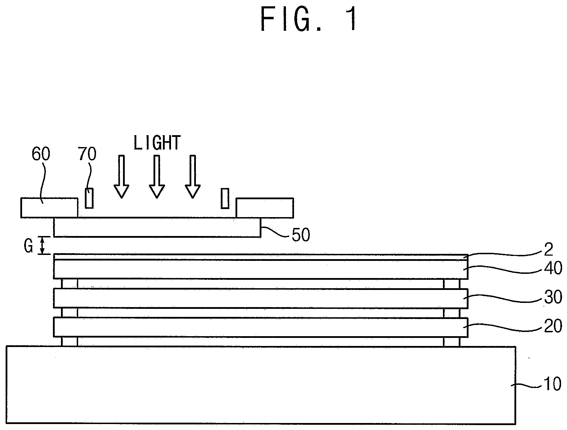

FIG. 1 is a conceptual diagram of an exposure device used in an exposure method according to an embodiment of the inventive concept.

Referring to FIG. 1, the exposure device may be a stepwise close-up exposure apparatus, and it is possible to expose a plurality of shots while moving a position of a substrate 2 to be processed.

In an embodiment, the exposure device may include a base 10, a stage, a work chuck 40, a mask 50, a mask holder 60, and an alignment detection system 70.

The stage, the work chuck 40, the mask holder 60, the alignment detection system 70, and a light source unit may be provided on the base 10.

The stage may be configured to relatively move the substrate 2 and the mask 50 and includes, for example, an XY stage 20 and a tilt stage 30. The XY stage 20 may move the substrate 2 in X and Y directions and rotation and inclination of the substrate 2 can be controlled by the tilt stage 30. In addition, the exposure device may further include a structure for adjusting a gap G between the substrate 2 and the mask 50. Although the XY stage 20 and the tilt stage 30 are described as being included with the substrate 2 and the mask 50 in order to relatively move the substrate 2 and the mask 50, the present disclosure is not limited thereto.

The work chuck 40 may adsorb and fix and support the substrate 2 to be a work object.

In an embodiment, the mask holder 60 may hold the mask 50 by a vacuum.

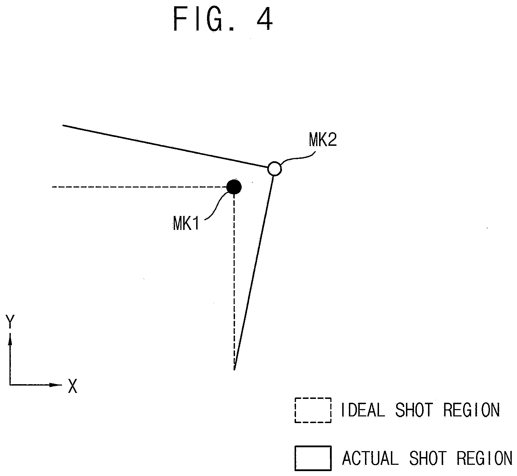

The alignment detection system 70 may detect a first alignment mark (refer to MK1 in FIG. 4) of the substrate 2 and a second alignment mark (refer to MK2 in FIG. 4) of the mask 50. In an embodiment, the alignment detection system 70 may be arranged corresponding to four corners of the mask 50 having a rectangular shape.

In an embodiment, the exposure device further includes a gap sensor for measuring the gap G which is a distance between the mask 50 and the substrate 2 and a light source unit (not shown) for generating light for irradiating the substrate 2 through the mask 50.

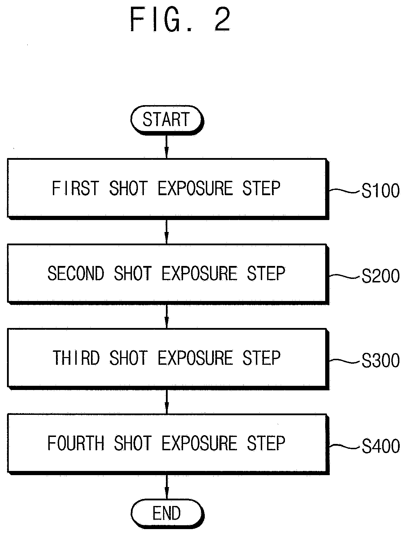

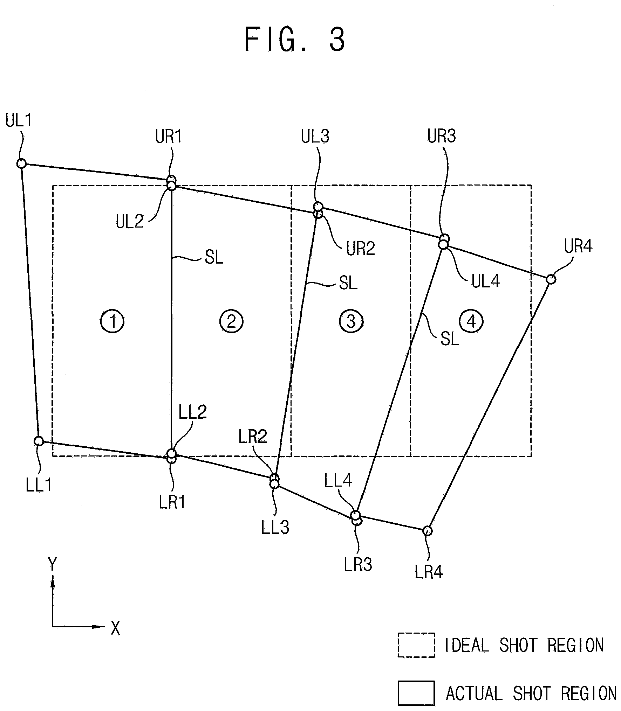

FIG. 2 is a flowchart showing an exposure method according to an embodiment of the inventive concept; FIG. 3 is a plan view showing a plurality of shot areas formed according to the exposure method of FIG. 2; and FIG. 4 is an enlarged plan view showing an alignment mark of a substrate and an alignment mark of a mask at a corner portion of a first shot region in FIG. 3.

Referring to FIGS. 2 to 4, in an embodiment, the exposure method may include a first shot exposure step S100, a second shot exposure step S200, a third shot exposure step S300, and a fourth shot exposure step S400. In the present embodiment, the substrate 2 is divided into four regions and the exposure process is completed by four shots. However, the substrate 2 may be divided into N regions (where N is a natural number of 3 or more), and the exposure process can be completed through the N shots. In addition, an arrangement of the regions may vary. For example, although four regions are arranged in the horizontal direction in one embodiment, they may be divided into three regions or six regions, for example.

Referring again to FIG. 3, the figure shows an ideal shot region (dotted line), that is, regions on the substrate 2, and an actual shot region (solid line). In an embodiment, the exposure region is divided into four regions which are exposed through the first to fourth shots for the entire region. However, the exposure region may be divided into an appropriate number as required. In the present embodiment, the ideal shot regions (dotted line) are regions on the substrate 20 where the shot should be made, and first to fourth regions are arranged in order along an X direction.

Here, one direction on a plane is defined as the X direction (X), a direction on the plane orthogonal to the X direction is defined as a Y direction (Y), a vertical direction orthogonal to the X direction and Y direction is defined as a Z direction, and a circumferential direction of an axis orthogonal to the X direction and the Y direction is defined as a $\theta$ direction.

In addition, the number of each shot is displayed on the drawing using a number in a circle (for example, the first shot is ① and the second shot is ②), and four corners of each shot are indicated by the number after the circled number. That is, a coordinate of an upper right corner UR1 of the first shot is (X①1, Y①1, θ①1), a coordinate of a lower right corner LR1 of the first shot is (X①2, Y①2, θ①2), a coordinate of a lower left corner LL1 of the first shot is (X①3, Y②3, θ①3), and a coordinate of an upper left corner UL1 of the first shot is (X①4, Y①4, θ①4).

A coordinate of an upper right corner UR2 of the second shot is (X②1, Y②1, θ②1), a coordinate of a lower right corner LR2 of the second shot is (X②2, Y②2, θ②2), a coordinate of a lower left corner LL2 of the second shot is (X②3, Y②3, θ②3), and a coordinate of an upper left corner UL2 of the second shot is (X②4, Y②4, θ②4).

A coordinate of an upper right corner UR3 of the third shot is (X③1, Y③1, θ③1), a coordinate of a lower right corner LR3 of the third shot is (X③2, Y③2, θ③2), a coordinate of a lower left corner LL3 of the third shot is (X③3, Y③3, θ③3), and a coordinate of an upper left corner UL3 of the third shot is (X③4, Y③4, θ③4).

A coordinate of an upper right corner UR4 of the fourth shot is (X④1, Y④1, θ④1), a coordinate of a lower right corner LR4 of the fourth shot is (X④2, Y④2, θ④2), a coordinate of a lower left corner LL4 of the fourth shot is (X④3, Y④3, θ④3), and a coordinate of an upper left corner UL4 of the fourth shot is (X④4, Y④4, θ④4).

Here, each coordinate represents (X coordinate, Y coordinate, and θ value which is the amount rotated on the XY plane), and the values related to θ can be calculated as follows:

$$\theta①k = \tan^{-1}\frac{(Y①k - Y①kc)}{(X①k - X①kc)}$$

$$\theta①c = \sum_{k=1}^{4}(\theta①k-\theta①k0)/4$$

where k is the corner number, and c is average of the four corners of each shot.

At this time, a stitch line SL is formed at a boundary of each shot. Although in the figures, the right side of the first shot and the left side of the second shot coincide with each other, it may actually be offset by a certain amount (e.g., a predetermined amount) within an alignment offset range. When the mask 50 is moved and aligned by the exposure device, accuracy of a position that the alignment detection system 70 can detect is greater than accuracy with which the mask 50 can be moved, such that an exposure process can proceed as it is aligned when the mask 50 comes close to alignment position within the predetermined range. At this time, an allowable error range can be defined as the alignment offset range.

On the other hand, a first alignment mark (refer to MK 1 in FIG. 4) may be placed on the substrate 2 at the corners of each ideal shot region. The corners (UL1 to LR4) of each shot correspond to the corners of each exposed region. Accordingly, the corners UL1 to LR4 may show positions of the second alignment marks (refer to MK2 in FIG. 4) corresponding to the respective corners of the mask 50.

Herein, the above exposure method will be described in further detail with reference to FIGS. 2 and 3.

In the first shot exposure step S100, two points UR1 and LR1 can be aligned with respect to one side of the ideal shot region (the right side reference in this embodiment).

The mask 50 can be moved to the first shot position (ideal position) and then aligned. An exposure position of the first shot (the exposure position means center coordinate of two aligned points, here, center coordinates of the right side) can be aligned using the following equations:

$$X① = -(X①1+X①2)/2$$

$$Y① = -(Y①1+Y①2)/2$$

$$\theta① = -(\theta①1+\theta①2)/2.$$

Thus, the mask 50 can be moved and aligned to a first shot coordinate (X①, Y①, θ①), and then the first shot can be exposed.

At this time, as described above, when the first shot is exposed, the actual position of the mask 50 may be misaligned with the coordinates (X①, Y①, θ①) within the alignment offset range. The exposure apparatus may detect and store misalignment (ΔX①, ΔY①, Δθ①).

Thereafter, in the second shot exposure step S200, two points (UL2, LL2) can be aligned with respect to the stitch line SL. At this time, in order to set a target position of the next shot (third shot), the coordinates of the two points on the opposite side (UR2 and LR2) can be detected.

The mask 50 may be moved to a second shot position (ideal position) and then aligned. An exposure position of the second shot (center coordinate of two aligned points) can be aligned using the following equations:

$$X② = \Delta X①-(X②3+X②4)/2$$

$$Y② = \Delta Y①-(Y②3+Y②4)/2$$

$$\theta② = \Delta\theta①-(\theta②3+\theta②4)/2$$

Thus, the mask 50 can be moved and aligned to a second shot coordinate (X②, Y②, θ②), and then the second shot can be exposed. At this time, since the exposure position is determined in consideration of the misalignment, error due to the alignment offset may not accumulate.

At this time, it is possible to detect a difference (ΔX②', ΔY②', Δθ②') between the coordinates of the ideal shot of the two points on the opposite side, i.e., the right corners (UR2, LR2), and the actual measured coordinates.

Thereafter, in the third shot exposure step (S300), two points (UL3, LL3) can be aligned with respect to the stitch line SL. At this time, in order to set a target position of the next shot (fourth shot), the coordinates of the two points UR3 and LR3 on the opposite side can be detected.

Specifically, the mask 50 may be moved to a third shot position (ideal position), and then aligned. An exposure position of the third shot (center coordinate of two aligned points) can be aligned using the following equations:

$$X_{③} = \Delta X_{②}' - (X_{③}3 + X_{③}4)/2$$

$$Y_{③} = \Delta Y_{②}' - (Y_{③}3 + Y_{③}4)/2$$

$$\theta_{③} = \Delta\theta_{②}' - (\theta_{③}3 + \theta_{③}4)/2.$$

Thus, the mask 50 can be moved and aligned to a third shot coordinate $(X_{③}, Y_{③}, \theta_{③})$, and then the third shot can be exposed. At this time, since the two target points (UR3 and LR3) are the values detected in the previous shot, errors due to alignment offsets may not accumulate.

At this time, it is possible to detect a difference $(\Delta X_{③}', \Delta Y_{③}', \Delta\theta_{③}')$ between the coordinates of the ideal shot of the two points on the opposite side, i.e., the right corners (UR3, LR3), and the actual measured coordinates.

Thereafter, in the fourth shot exposure step S400, two points (UL4, LL4) can be aligned with respect to the stitch line SL. In this embodiment, since the fourth shot is the last shot, it is not necessary to detect the coordinates of the two points on the opposite side (UR4, LR4) in order to set a target position of the next shot.

The mask 50 may be moved to a forth shot position (ideal position), and then aligned. An exposure position of the fourth shot (center coordinate of two aligned points) can be aligned using the following equations:

$$X_{④} = \Delta X_{③}' - (X_{④}3 + X_{④}4)/2$$

$$Y_{④} = \Delta Y_{③}' - (Y_{④}3 + Y_{④}4)/2$$

$$\theta_{④} = \Delta\theta_{③}' - (\theta_{④}3 + \theta_{④}4)/2.$$

Thus, the mask 50 can be moved and aligned to a fourth shot coordinate $(X_{④}, Y_{④}, \theta_{④})$, and then the fourth shot can be exposed.

On the other hand, the actual shot region may be different in size and shape from shot to shot depending on the surrounding environment at the time of exposure. The actual shot region shown in the figure may be exaggerated and distorted, as an example in which the actual shot region deviates from the rectangular shape for each shot is shown, but the present disclosure is not limited thereto.

According to the present embodiment, since the respective shots are aligned at two points with respect to the stitch line SL, unevenness of exposure in the stitch line SL portion of the plurality of shots can be minimized or reduced.

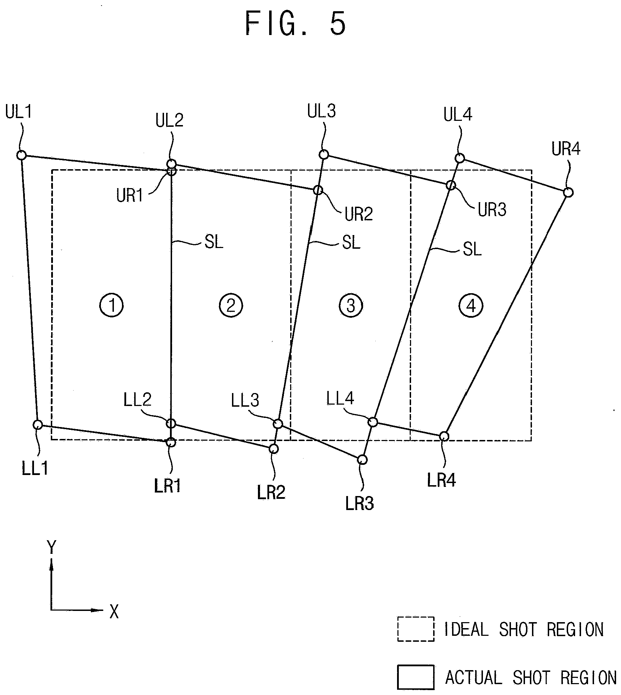

FIG. 5 is a plan view showing a plurality of shot regions formed according to an exposure method according to an embodiment of the inventive concept.

Referring to FIGS, 2 and 5, the exposure method may include a first shot exposure step S100, a second shot exposure step S200, a third shot exposure step S300, and a fourth shot exposure step S400.

The contents indicated by the following coordinates, for example, the coordinates $(X_{①}1, Y_{①}1, \theta_{①}1)$ of the upper right corner UR1 of the first shot and the like are the same as in the exposure method of FIGS. 1 to 4, and a further detailed description thereof will be omitted.

In the exposure method according to the present embodiment, in order to minimize or reduce an increase in error in a Y direction as the shots are accumulated in the exposure method of FIGS. 1 to 4, the shot is slid along the stitch line SL in a direction of decreasing Y-direction error with two points alignment. Herein, this will be described in further detail.

In the first shot exposure step S100, two points UR1 and LR1 can be aligned with respect to one side of the ideal shot region (the right side reference in this embodiment).

The mask 50 can be moved to the first shot position (ideal position) and then aligned. An exposure position of the first shot (the exposure position means center coordinate of two aligned points, here, center coordinates of the right side) can be aligned using the following equations:

$$X① = -(X①1+X①2)/2$$

$$Y① = -(Y①1+Y①2)/2$$

$$θ① = -(θ①1+θ①2)/2.$$

Accordingly, the mask 50 can be moved and aligned to the first shot coordinate (X①, Y①, θ①), and then the first shot can be exposed.

At this time, as described above, when the first shot is exposed, the actual position of the mask 50 may be misaligned with the coordinates (X①, Y①, θ①) within the alignment offset range. The exposure apparatus may detect and store misalignment (ΔX①, ΔY①, Δθ①).

Thereafter, in the second shot exposure step S200, two points (UL2, LL2) can be aligned with respect to the stitch line SL. At this time, in order to reduce error in the Y direction, it is slid along the stitch line SL by a certain amount (e.g., a predetermined amount) to be aligned. At this time, a target alignment coordinate (X②, Y②, θ②) of the mask 50 can be set by detecting and using coordinates of four points (UL2, LL2, UR2, LR2).

$$X② = ΔX①-(X②3+X②4)/2+ΔX②s$$

$$Y② = ΔY①-(Y②3+Y②4)/2+ΔY②s$$

$$θ② = Δθ①-(θ②3+θ②4)/2.$$

Here, the slip amounts ΔX②s, ΔY②s can be calculated by the following:

$$ΔY②a=\{[(Y②3+Y②4)/2]•(a/0.5)+[\sum_{i=1}^{4} (Y②k)/4•(1-a)/0.5]]/2$$

$$ΔY②s=ΔY②a-(Y②3+Y②4)/2$$

$$ΔX②s=ΔY②s•[(X①1-X①2)/(Y①1-Y①2)]$$

Here, "a" is a weight value, and a user can set it as needed. For example, when the weight value is 100%, that is, when a = 1, it is a method (two-point alignment) in which the Y-direction error is minimized or reduced using only the two points UL2 and LL2. When the weight is 0%, in order to reduce the Y-direction error, it is a method (four-point alignment) in which the Y-direction error is minimized or reduced by using all four points (UL2, LL2, UR2, LR2).

That is, the influence of the two-point alignment (stitch line direction) can be increased in the four-point alignment while the weight value changes from 0 to 100% (a = 0 to 1)

On the other hand, at this time, it is possible to arbitrarily adjust the slide amount by adding a an offset value (e.g., a predetermined offset value) to the slide amounts (ΔY②s, ΔX②s) depending on the process needs or experience.

Accordingly, the mask 50 can be moved and aligned to a second shot coordinate (X②, Y②, θ②), and then the second shot can be exposed. At this time, it is possible to detect a difference (ΔX②', ΔY②', Δθ②') between the coordinates of the ideal shot of the two points on the opposite side, i.e., the right corners (UR2, LR2), and the actual measured coordinates.

Thereafter, in the third shot exposure step (S300), to align two points (UL3, LL3) with respect to the stitch line SL but to reduce errors in the Y direction, it is aligned by sliding along the stitch line SL by a certain amount (e.g., a predetermined amount). At this time, a target alignment coordinates (X③, Y③, θ③) of the mask 50 can be set by detecting and using the coordinates of four points (UL3, LL3, UR3, LR3)

At this time, the target alignment coordinates (X③, Y③, θ③) of the mask 50 can be set by detecting and using the coordinates of four points (UL3, LL3, UR3, LR3).

$$X③ = \Delta X②-(X③3+X③4)/2+\Delta X③s$$

$$Y③ = \Delta Y②-(Y③3+Y③4)/2+\Delta Y③s$$

$$θ③ = \Delta θ②-(θ③3+θ③4)/2.$$

Here, the slip amounts ΔX②s, ΔY③s can be calculated by the following:

$$\Delta Y③a=\{[(Y③3+Y③4)/2]•(a/0.5)+[\sum_{k=1}^{4} (Y③k)/4•(1-a)/0.5]]/2$$

$$\Delta Y③s=\Delta Y③a-(Y③3+Y③4)/2$$

$$\Delta X③s=\Delta Y③s•[(X②1-X②2)/(Y②1-Y②2)].$$

Here, "a" is a weight value, and a user can set it as needed. In this case, the weight value may be the same as or different from the weight value in the second shot, and the offset value may be the same as or different from the weight value in the second shot.

Accordingly, the mask 50 can be moved and aligned to a third shot coordinate (X③, Y③, θ③), and then the third shot can be exposed. At this time, it is possible to detect the difference (ΔX②', ΔY②', Δθ②') between the coordinates of the ideal shot of the two points on the opposite side, i.e., the right corners (UR3, LR3) and the actually measured coordinates.

Thereafter, in the fourth shot exposure step (S400), to align two points (UL4, LL4) with respect to the stitch line SL but to reduce errors in the Y direction, it is aligned by sliding along the stitch line SL by a certain amount (e.g., a predetermined amount). At this time, a target alignment coordinates (X④, Y④, θ④) of the mask 50 can be set by detecting and using the coordinates of four points (UL4, LL4, UR4, LR4).

$$X④ = \Delta X③-(X④3+X④4)/2+\Delta X④s$$

$$Y④ = \Delta Y③-(Y④3+Y④4)/2+\Delta Y④s$$

$$θ④ = \Delta θ③-(θ④3+θ④4)/2$$

Here, the slip amounts ΔX④s, ΔY④s can be calculated by the following:

$$\Delta Y④a=\{[(Y④3+Y④4)/2]•(a/0.5)+[\sum_{k=1}^{4} (Y④k)/4•(1-a)/0.5]]/2$$

$$\Delta Y④s=\Delta Y④a-(Y④3+Y④4)/2$$

$$\Delta X④s=\Delta Y④s•[(X③1-X③2)/(Y③1-Y③2)]$$

Here, "a" is a weight value, and a user can set it as needed. In this case, the weight value may be the same as or different from the weight value in the third shot, and the offset value may be the same as or different from the weight value in the third shot.

Accordingly, the mask 50 can be moved and aligned to a fourth shot coordinate $(X④, Y④, θ④)$, and then the fourth shot can be exposed. At this time, since the fourth shot is the last shot, it is not necessary to detect the coordinates of the two points (UR4, LR4) on the opposite side in order to set a target position of the next shot.

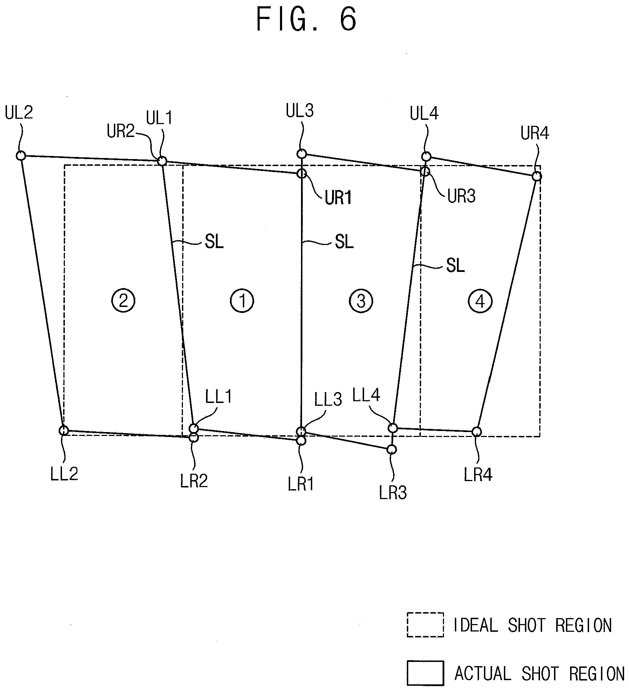

FIG. 6 is a plan view showing a plurality of shot regions formed according to an exposure method according to an embodiment of the inventive concept. Detection and alignment of coordinates at each step of the above exposure method is substantially the same as that of the exposure method of FIG. 5 except for a position of each shot. Therefore, repeated explanation will be omitted.

Referring to FIG. 2 and 6, the exposure method may include a first shot exposure step S100, a second shot exposure step S200, a third shot exposure step S300, and a fourth shot exposure step S400.

The substrate 2 may include first to fourth regions (dotted lines). The second region, the first region, the third region, and the fourth region are arranged in order along the X direction. First to fourth shots are sequentially exposed with respect to the first region, the second region, the third region and the fourth region.

In the first shot exposure step S100, a right side of the mask 50 is aligned with a right side of the first region, and then the first shot is exposed. In the second shot exposure step S200, a right side of the second shot is aligned with a left side of the first shot, and then the mask is slid along a stitch line SL, and then the second shot is exposed. In the third shot exposure step S300, a left side of the third shot is aligned with a right side of the first shot, and then the mask is slid along a stitch line SL, and then the third shot is exposed. In the fourth shot exposure step S400, a left side of the fourth shot is aligned with a right side of the third shot, and then the mask is slid along a stitch line SL, and then the fourth shot is exposed.

According to the present embodiment, an exposure sequence for each region on the substrate 2 can be adjusted to minimize or reduce error accumulation in the X direction and the Y direction while performing uniform exposure. In a case of exposing four regions with four shots, in an embodiment, the first shot is aligned with a center line of the substrate 2, that is, a right side of second located region (first region). As another example, if the exposure is performed with six shots for six regions, it may be preferable to align a right side of third located region to expose the first shot.

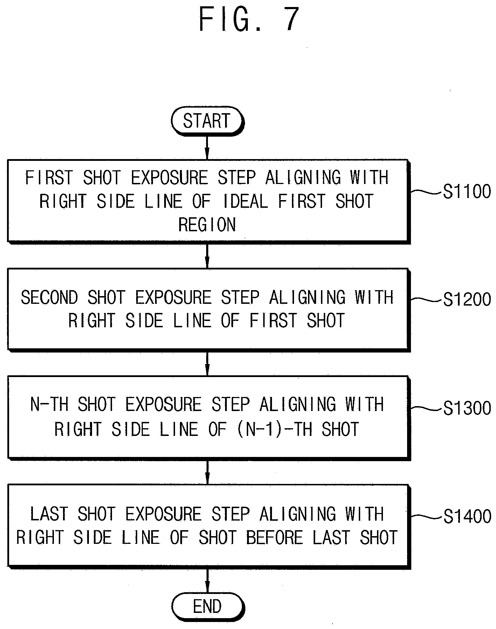

FIG. 7 is a flowchart illustrating an exposure method according to an embodiment of the inventive concept.

Referring to FIG. 7, an exposure method may include a first shot exposure step aligning with a right side line of an ideal first shot region (S1100), a second shot exposure step aligning with a right side line of the first shot (S1200), a N-th shot exposure step aligning with a right side line of (N-1)-th shot (S1300), and a last shot exposure step aligning with a right side line of a shot before the last shot (S1400). Here, N is a natural number of 2 or more, and the last shot (m-th shot) may be more than a third shot.

The above exposure method is a method for stepwise moving a rectangular mask and a relative position of a substrate, which is divided into m regions, and m times exposing each of the regions to each shot.

In the first shot exposure step S1100, the mask is located on the first region of the substrate, a right side of the mask is aligned with a right side of the first region, and then the first shot is exposed.

In the second shot exposure step S1200, the mask is located on the second region of the substrate, a left side of the mask is aligned with a right side of the first shot, and then the second shot is exposed.

In the N-th shot exposure step S1300, the mask is located on the N-th region of the substrate, a left side of the mask is aligned with a right side of (N-1)-th shot, and then the N-th shot is exposed.

In the last shot exposure step S1400, the mask is located on the m-th region of the substrate, a left side of the mask is aligned with a right side of (m-1)-th shot (previous to the last shot), and then the m-th shot is exposed.

In an embodiment, each shot is aligned using the right side of the previous shot, but the present disclosure is not limited thereto. That is, it is also possible to align them using the right side or the left side. As in the exposure method of FIG. 6, it is also possible to align with the right side or the left side as necessary. That is, the exposure method can be applied variously on the basis of aligning with a stitch line formed by a present shot.

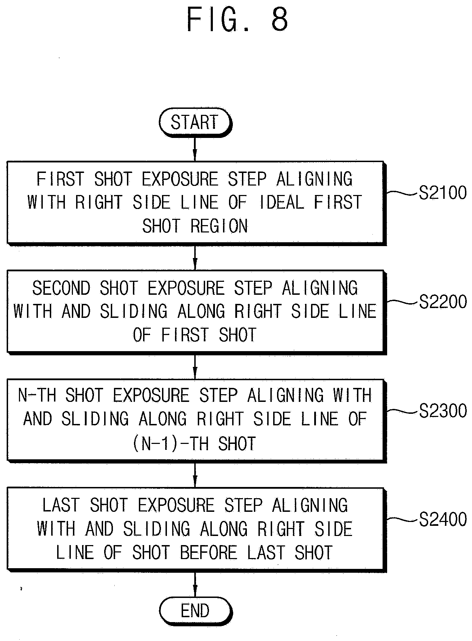

FIG. 8 is a flowchart illustrating an exposure method according to an embodiment of the inventive concept.

Referring to FIG. 8, the exposure method may include a first shot exposure step aligning with a right side line of an ideal first shot region (S2100), a second shot exposure step aligning with and sliding along a right side line of the first shot (S2200), a N-th shot exposure step aligning with and sliding along a right side line of (N-1)-th shot (S2300), and a last shot exposure step aligning with and sliding along a right side line of a shot before the last shot (S2400). Here, N is a natural number of 2 or more, and the last shot (m-th shot) may be more than a third shot.

In the exposure method, a rectangular mask and a relative position of the substrate are moved in a stepwise manner with respect to a substrate divided into m regions, and the m regions are divided into respective m times exposure shots.

In the first shot exposure step S2100, the mask is located on the first region of the substrate, a right side of the mask is aligned with a right side of the first region, and then the first shot is exposed.

In the second shot exposure step S2200, the mask is located on the second region of the substrate, a left side of the mask is aligned along a right side of the first shot by a predetermined amount or a calculated amount and aligned, and then the second shot is exposed.

In the N-th shot exposure step S2300, the mask is located on the N-th region of the substrate, a left side of the mask is aligned along a right side of the (N-1)-th shot by a predetermined amount or a calculated amount and aligned, and then the N-th shot is exposed.

In the last shot exposure step S2400, the mask is located on the m-th region of the substrate, a left side of the mask is aligned along a right side of the right side of (m-1)-th shot (previous to the last shot) by a predetermined amount or a calculated amount and aligned, and then the last shot is exposed.

In an embodiment, each shot is aligned using the right side of the previous shot, but the present disclosure is not limited thereto. That is, it is also possible to align them using the right side or the left side. As in the exposure method of FIG. 6, it is also possible to align with the right side or the left side as necessary. That is, the exposure method can be applied variously on the basis of aligning with a stitch line formed by a present shot.

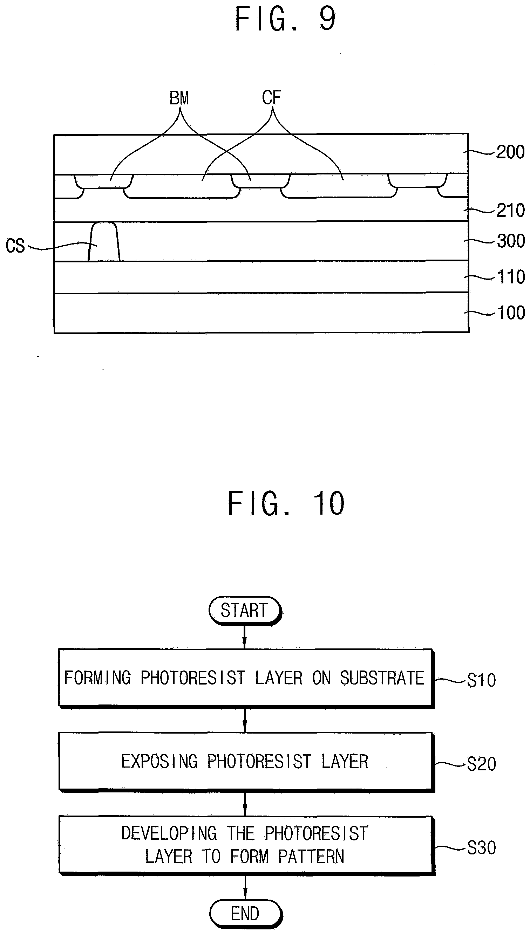

FIG. 9 is a cross-sectional view illustrating a display apparatus manufactured using an exposure method according to an embodiment of the inventive concept.

Referring to FIG. 9, a display apparatus may include a first base substrate 100, a circuit element layer 110, a second base substrate 200, a black matrix BM, a color filter CF, an overcoat layer 210, a column spacer CS, and a liquid crystal layer 300.

The first base substrate 100 may include a transparent insulating substrate. For example, the first base substrate 100 may include a glass substrate, a quartz substrate, a transparent resin substrate, or the like.

The circuit element layer 110 may be disposed on the first base substrate 100. The circuit element layer 110 may include a plurality of conductive pattern layers and a plurality of insulating layers for insulating therebetween. For example, the circuit element layer 110 may include a thin film transistor, a gate line, a data line, a storage capacitor, a pixel electrode, and the like.

The second base substrate 200 may be disposed to face the first base substrate 100. The second base substrate 200 may include a transparent insulating substrate. For example, the second base substrate 200 may include a glass substrate, a quartz substrate, a transparent resin substrate, or the like.

The black matrix BM may be disposed on the second base substrate 200. The black matrix BM may include a material blocking light. The black matrix BM may be disposed between each pixel region to divide each pixel region.

The color filter CF may be disposed on the second base substrate 200 on which the black matrix BM is disposed. The color filter CF is for providing color to light transmitted through the liquid crystal layer 300. The color filter CF may be a red color filter (red), a green color filter (green), and a blue color filter (blue). The color filters CF may be provided corresponding to the pixels, and may be arranged to have different colors between adjacent pixels.

The overcoat layer 210 may be formed on the color filter CF and the black matrix BM. The overcoat layer 210 functions to protect the color filter CF while flattening the color filter CF and, in an embodiment, may be formed using an acrylic epoxy material.

The liquid crystal layer 300 may be disposed between the first and second base substrates 100 and 200. The liquid crystal layer 300 may include liquid crystal molecules having optical anisotropy. The liquid crystal molecules are driven by an electric field to transmit or block light passing through the liquid crystal layer 300 to display an image. The column spacer CS can maintain a cell gap between the upper substrate and the lower substrate on which the liquid crystal layer 300 is disposed.

In an embodiment, patterns such as the color filter CF, the column spacer CS, the black matrix BM, etc. are formed through exposure and development processes. When a size of the display apparatus is larger than a mask used for exposure, an exposure process can be performed using the exposure method according to embodiments of the present disclosure.

At this time, when the exposure method according to embodiments of the present disclosure is used, unevenness of exposure in a stitch line of the patterns is reduced, such that stitch stains can be reduced.

In the present embodiment, a liquid crystal display apparatus is taken as an example, but the present disclosure is not limited to this. For example, the display apparatus may be an organic light emitting display apparatus, and a pattern to be manufactured through the exposure and development process of the organic light emitting display apparatus may be formed using the exposure method.

FIG. 10 is a flowchart showing a method of manufacturing a display apparatus using an exposure method according to an embodiment of the inventive concept.

Referring to FIG. 10, a method of manufacturing the display apparatus may include forming a photoresist layer on a substrate (S10), exposing the photoresist layer (S20), and developing the exposed photoresist layer to form a pattern (S30).

In forming the photoresist layer on the substrate (S10), a photoresist layer may be formed on a substrate. The photoresist layer may be formed by applying a photoresist to a thickness (e.g., a predetermined thickness) on the substrate.

In the exposing the photoresist layer (S20), light is irradiated to expose the photoresist layer using an exposure device including a mask for forming a pattern. At this time, the exposure method according to embodiments of the present disclosure can be used.

In the developing the exposed photoresist layer to form a pattern (S30), the exposed photoresist layer can be developed to form a desired pattern. The pattern may be, for example, a color filter of a liquid crystal display, a column spacer, a black matrix, or the like, as described above.

The foregoing is illustrative of the inventive concept and is not to be construed as limiting thereof. Although some embodiments of the inventive concept have been described, those skilled in the art will readily appreciate that many modifications are possible in the embodiments without materially departing from the novel teachings and aspects of the inventive concept. Accordingly, all such modifications are intended to be included within the scope of the inventive concept as set forth in the claims. Therefore, it is to be understood that the foregoing is illustrative of the inventive concept and is not to be construed as limited to the specific embodiments disclosed, and that modifications to the disclosed embodiments, as well as other embodiments, are intended to be included within the scope of the appended claims. The inventive concept is set forth in the following claims.

**Claims**

1. An exposure method for stepwise moving a rectangular mask and a relative position of a substrate, which is divided into a plurality of regions, and exposing each of the regions to a shot, the exposure method comprising:

   a first shot exposure step comprising locating the mask on a first region of the plurality of regions of the substrate, detecting first coordinates of two points on one side of the mask, aligning the mask using the first coordinates, and then exposing a first shot;
   a second shot exposure step comprising locating the mask on a second region of the plurality of regions of the substrate, detecting second coordinates of two points on one side of the mask adjacent to the first region, aligning the mask using the second coordinates, and then exposing a second shot; and
   a third shot exposure step comprising locating the mask on a third region of the plurality of regions of the substrate, detecting third coordinates of two points on one side of the mask adjacent to an already exposed adjacent shot region, aligning the mask using the third coordinates, and then exposing a third shot.

2. The exposure method of claim 1, wherein the first region, the second region, and the third region are sequentially continuously arranged,
   alignment in the first shot exposure step is performed by aligning one side of the mask with one side of the first region,
   alignment in the second shot exposure step is performed by aligning one side of the mask with one side of the first shot, and
   alignment in the third shot exposure step is performed by aligning one side of the mask with one side of the second shot.

3. The exposure method of claim 2, wherein, in the first shot exposure step, the first shot is exposed when the mask is located within an alignment offset range, and
   in the second shot exposure, the mask is aligned using a difference amount that is offset from an alignment target coordinate.

4. The exposure method of claim 3, further comprising, in the second shot exposure step, detecting and storing coordinates of two other points opposite to the two points at which the alignment is performed when the second shot is exposed, and
   the mask is aligned using the coordinates of the two other points in the third shot exposure.

5. The exposure method of claim 4, further comprising, in the second shot exposure step, calculating an alignment target coordinate $(X_②, Y_②, \theta_②)$ of the mask by the following equations:

$$X_② = \Delta X_① - (X_②3 + X_②4)/2 + \Delta X_②s$$

$$Y② = ΔY①-(Y②3+Y②4)/2+ΔY②s$$

$$θ② = Δθ①-(θ②3+θ②4)/2$$

wherein slip amounts ΔX②s, ΔY②s are calculated by the following equations:

$$ΔY②a=\{[(Y②3+Y②4)/2]•(a/0.5)+[\sum_{k=1}^{4} (Y②k)/4•(1-a)/0.5]]/2$$

$$ΔY②s=ΔY②a-(Y②3+Y②4)/2$$

$$ΔX②s=ΔY②s•[(X①1-X①2)/(Y①1-Y①2)]$$

wherein "a" is a weight value and is set to a value between 0 and 1,
detecting coordinates of the two other points opposite to the two points at which the alignment is performed when the second shot is exposed, detecting a difference amount (ΔX②', ΔY②', Δθ②') between the coordinates of the two other points which and storing coordinates of corresponding two points in the second region.

6. The exposure method of claim 5, further comprising, in the third shot exposure step, calculating the alignment target coordinate (X③, Y③, θ③) of the mask by the following equations:

$$X③ = ΔX②-(X③3+X③4)/2+ΔX③s$$

$$Y③ = ΔY②-(Y③3+Y③4)/2+ΔY③s$$

$$θ③ = Δθ②-(θ③3+θ③4)/2$$

wherein slip amounts ΔX②s, ΔY②s are calculated by the following equations:

$$ΔY③a=\{[(Y③3+Y③4)/2]•(a/0.5)+[\sum_{k=1}^{4} (Y③k)/4•(1-a)/0.5]]/2$$

$$ΔY③s=ΔY③a-(Y③3+Y③4)/2$$

$$ΔX③s=ΔY③s•[(X②1-X②2)/(Y②1-Y②2)]$$

wherein "a" is a weight value and is set to a value between 0 and 1,
detecting coordinates of two other points opposite to the two points at which the alignment is performed when the third shot is exposed, detecting a difference amount (ΔX③', ΔY③', Δθ③') between the coordinates of the other two points which and storing coordinates of corresponding two points in the third region.

7. The exposure method of claim 6, wherein the weight value "a" in the second shot exposure step and the weight value "a" in the third shot exposure step are different from each other.

8. The exposure method of any of claims 5 to 7, wherein, in the second shot exposure step, an amount by which an additional offset value is further added to the slide amounts ΔX②s, ΔY②s is slid.

9. The exposure method of any preceding claim, wherein detected coordinates and aligned coordinates have values of $(X, Y, \theta)$, respectively, where X is an X coordinate, Y is a Y coordinate, and $\theta$ is calculated by the following equation:

$$\theta①k = \tan^{-1} \frac{(Y①k - Y①kc)}{(X①k - X①kc)}$$

$$\theta①c = \sum_{k=1}^{4}(\theta①k - \theta①k0)/4$$

where k is a corner number, and c is average of four corners of each shot,
in the first shot exposure step, the coordinates of the two points detected are $(X①1, Y①1, \theta①1)$ and $(X①2, Y①2, \theta①2)$,
in the first shot exposure step, the alignment target coordinate $(X①, Y①, \theta①)$ of the mask is calculated by the following equations:

$$X① = -(X①1+X①2)/2$$

$$Y① = -(Y①1+Y①2)/2$$

$$\theta① = -(\theta①1+\theta①2)/2$$

and wherein the method further comprises storing a difference amount $(\Delta X①, \Delta Y①, \Delta\theta①)$ between an actual position of the mask and the alignment target coordinate $(X①, Y①, \theta①)$ within an alignment offset range when the first shot is exposed.

10. The exposure method of claim 9, wherein in the second shot exposure step, the coordinates of the two points detected are $(X②3, Y②3, \theta②3)$ and $(X②4, Y②4, \theta②4)$,
in the second shot exposure step, the alignment target coordinate $(X②, Y②, \theta②)$ of the mask is calculated by the following equations:

$$X② = \Delta X①-(X②3+X②4)/2$$

$$Y② = \Delta Y①-(Y②3+Y②4)/2$$

$$\theta② = \Delta\theta①-(\theta②3+\theta②4)/2$$

and wherein the method further comprises detecting coordinates of two other points opposite to the two points at which the alignment is performed when the second shot is exposed, and storing a difference amount $(\Delta X②', \Delta Y②', \Delta\theta②')$ between the coordinates of the two other points which are detected and coordinates of corresponding two points in the second region.

11. The exposure method of claim 10, wherein in the third shot exposure step, the coordinates of the two points detected are $(X③3, Y③3, \theta③3)$ and $(X③4, Y③4, \theta③4)$, and
in the third shot exposure step, the alignment target coordinate $(X③, Y③, \theta③)$ of the mask is calculated by the following equations:

$$X③ = \Delta X②'-(X③3+X③4)/2$$

$$Y③ = ΔY②' -(Y③3+Y③4)/2$$

$$θ③ = Δθ②'-(θ③3+θ③4)/2.$$

**12.** The exposure method of claim 11, further comprising, in the third shot exposure step,
detecting coordinates of two other points opposite to the two points at which the alignment is performed when the third shot is exposed, detecting a difference amount (ΔX③', ΔY③', Δθ③') between the coordinates of the other two points which and storing coordinates of corresponding two points in the third region,
wherein, in the fourth shot exposure step, the coordinates of the two points detected are (X④3, Y④3, θ④3) and (X④4, Y④4, θ④4), and
wherein, in the fourth shot exposure, the alignment target coordinate (X④, Y④, θ④) of the mask is calculated by the following equations:

$$X④ = ΔX③'-(X④3+X④4)/2$$

$$Y④ = ΔY③'-(Y④3+Y④4)/2$$

$$θ④ = Δθ③'-(Θ④3+θ④4)/2.$$

**13.** The exposure method of any preceding claim, wherein the first region is between the second region and the third region.

**14.** The exposure method of any preceding claim, further comprising, in the second shot exposure step, sliding the mask along a stitch line formed by contacting the first shot and the second shot by a certain amount to be aligned.

**15.** The exposure method of claim 14, further comprising, in the second shot exposure step, determining an amount of sliding of the mask by using the coordinates of four points of the mask.

# FIG. 1

# FIG. 2

START

| FIRST SHOT EXPOSURE STEP | ~S100 |

| SECOND SHOT EXPOSURE STEP | ~S200 |

| THIRD SHOT EXPOSURE STEP | ~S300 |

| FOURTH SHOT EXPOSURE STEP | ~S400 |

END

# FIG. 3

IDEAL SHOT REGION

ACTUAL SHOT REGION

# FIG. 4

MK2

MK1

Y

X

☐ IDEAL SHOT REGION

☐ ACTUAL SHOT REGION

# FIG. 5

# FIG. 6

IDEAL SHOT REGION

ACTUAL SHOT REGION

# FIG. 7

```
        ( START )
            │
            ▼
┌────────────────────────────────────┐
│ FIRST SHOT EXPOSURE STEP ALIGNING   │──── S1100
│ WITH RIGHT SIDE LINE OF IDEAL FIRST │
│ SHOT REGION                         │
└────────────────────────────────────┘
            │
            ▼
┌────────────────────────────────────┐
│ SECOND SHOT EXPOSURE STEP ALIGNING  │──── S1200
│ WITH RIGHT SIDE LINE OF FIRST SHOT  │
└────────────────────────────────────┘
            │
            ▼
┌────────────────────────────────────┐
│ N-TH SHOT EXPOSURE STEP ALIGNING    │──── S1300
│ WITH RIGHT SIDE LINE OF (N-1)-TH    │
│ SHOT                                │
└────────────────────────────────────┘
            │
            ▼
┌────────────────────────────────────┐
│ LAST SHOT EXPOSURE STEP ALIGNING    │──── S1400
│ WITH RIGHT SIDE LINE OF SHOT BEFORE │
│ LAST SHOT                           │
└────────────────────────────────────┘
            │
            ▼
         ( END )
```

# FIG. 8

```
                    ( START )
                        │
                        ▼
    ┌───────────────────────────────────────┐
    │  FIRST SHOT EXPOSURE STEP ALIGNING     │      S2100
    │  WITH RIGHT SIDE LINE OF IDEAL FIRST   │
    │            SHOT REGION                  │
    └───────────────────────────────────────┘
                        │
                        ▼
    ┌───────────────────────────────────────┐
    │  SECOND SHOT EXPOSURE STEP ALIGNING    │      S2200
    │  WITH AND SLIDING ALONG RIGHT SIDE LINE│
    │            OF FIRST SHOT               │
    └───────────────────────────────────────┘
                        │
                        ▼
    ┌───────────────────────────────────────┐
    │  N-TH SHOT EXPOSURE STEP ALIGNING WITH │      S2300
    │  AND SLIDING ALONG RIGHT SIDE LINE OF  │
    │            (N-1)-TH SHOT               │
    └───────────────────────────────────────┘
                        │
                        ▼
    ┌───────────────────────────────────────┐
    │  LAST SHOT EXPOSURE STEP ALIGNING      │      S2400
    │  WITH AND SLIDING ALONG RIGHT SIDE     │
    │     LINE OF SHOT BEFORE LAST SHOT      │
    └───────────────────────────────────────┘
                        │
                        ▼
                     ( END )
```

# FIG. 9

BM      CF

~200

~210

CS

~300

~110

~100

# FIG. 10

START

| FORMING PHOTORESIST LAYER ON SUBSTRATE | ~S10 |

| EXPOSING PHOTORESIST LAYER | ~S20 |

| DEVELOPING THE PHOTORESIST LAYER TO FORM PATTERN | ~S30 |

END

Europäisches
Patentamt

European
Patent Office

Office européen
des brevets

# EUROPEAN SEARCH REPORT

Application Number

EP 19 20 1008

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 440 138 A (NISHI KENJI [JP]) 8 August 1995 (1995-08-08) | 1-3, 10-15 | INV. G03F7/20 |
| Y | * column 6, line 10 - column 9, line 26 * | 4,9 | |
| A | * figures 1,2,5 * | 5-8 | |
| Y | KR 2016 0132191 A (SAMSUNG DISPLAY CO LTD [KR]) 17 November 2016 (2016-11-17) | 4 | |
| A | * paragraph [0035] - paragraph [0038] * * figures 6-8 * | 1,5-8 | |
| Y | US 2007/009813 A1 (FUJITA YASUO [JP]) 11 January 2007 (2007-01-11) | 9 | |
| A | * paragraph [0037] - paragraph [0044] * * figure 6 * | 1,5-8 | |
| A | JP H05 197158 A (NIKON CORP) 6 August 1993 (1993-08-06) * the whole document * | 1 | |

TECHNICAL FIELDS SEARCHED (IPC)

G03F

The present search report has been drawn up for all claims

| Place of search | Date of completion of the search | Examiner |
|---|---|---|
| Munich | 12 March 2020 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 640 736 A1**

## ANNEX TO THE EUROPEAN SEARCH REPORT
## ON EUROPEAN PATENT APPLICATION NO.

EP 19 20 1008

12-03-2020

| Patent document cited in search report | | Publication date | Patent family member(s) | | Publication date |
|---|---|---|---|---|---|
| US 5440138 | A | 08-08-1995 | JP | 3198310 B2 | 13-08-2001 |
| | | | JP | H06204105 A | 22-07-1994 |
| | | | US | 5440138 A | 08-08-1995 |
| KR 20160132191 | A | 17-11-2016 | CN | 106125517 A | 16-11-2016 |
| | | | KR | 20160132191 A | 17-11-2016 |
| US 2007009813 | A1 | 11-01-2007 | CN | 1904686 A | 31-01-2007 |
| | | | JP | 4854998 B2 | 18-01-2012 |
| | | | JP | 2007017465 A | 25-01-2007 |
| | | | KR | 20070005499 A | 10-01-2007 |
| | | | TW | 200702807 A | 16-01-2007 |
| | | | US | 2007009813 A1 | 11-01-2007 |
| JP H05197158 | A | 06-08-1993 | JP | 3383994 B2 | 10-03-2003 |
| | | | JP | H05197158 A | 06-08-1993 |

EPO FORM P0459

For more details about this annex : see Official Journal of the European Patent Office, No. 12/82